# EUROPEAN PATENT APPLICATION

(11) **EP 4 641 633 A1**
(43) Date of publication of application: **29.10.2025**
(21) Application number: 24172826.0
(22) Date of filing: 26.04.2024
(51) Int. Cl.: H01L 23/495

(54) **VERTICAL GAN DEVICE**

(71) Applicant: Infineon Technologies Austria AG, 9500 Villach (AT)
(72) Inventor: LIVELO, Emmanuel Inoferio, 6017 Cebu (PH); TAHAR, Noor Asifa, 75260 Krubong (MY); LEE, Chai Chee, 75000 Bandar Hilir (MY); BASALO, Suzanne Mary Valmores, 6015 Cebu, Lapu-Lapu City (PH)
(74) Representative: Lambsdorff & Lange Patentanwälte Partnerschaft mbB

(57) **Abstract**

A chip package includes a first plate-shaped metal carrier structure, a second plate-shaped metal carrier structure and a third plate-shaped metal carrier structure. The chip package further includes a first GaN chip sandwiched between the first metal carrier structure and the second metal carrier structure and a second GaN chip sandwiched between the second metal carrier structure and the third metal carrier structure. The chip package is configured to be attached to an application board in an orientation in which the plate-shaped metal carrier structures and the GaN chips are inclined, in particular vertical relative to the application board.

## Description

### Technical Field

This disclosure relates generally to the technique of semiconductor packaging, and in particular to a GaN chip package.

### Background

Packaging techniques can have a high impact on device performance. Packaging concepts may aim to provide a high routing capability, a high variability of footprint design, a good board level reliability (e.g., high thermal cycling on board (TCoB) performance) and good thermal dissipation into the board as well as low assembly cost. Moreover, in particular for power applications, the packaging concept should provide for miniaturization (reduction of the footprint area), electrical efficiency and low R_{DS(on)} (reduction of conduction losses and other losses), thermal efficiency, reduction of package parasitics and electromagnetic interference (EMI) safety (i.e., low radiated emissions), for example.

Chips based on GaN and silicon have principal differences. Special package concepts are needed for GaN chips, e.g. GaN transistor chips. Some package concepts rely on laminate-based package solutions. By doing so, the footprint design of the device is no longer limited by the pad layout of the chip. However, the usage of laminate in packaging leads to higher package cost and limitations in terms of solder materials which can be used. Further, due to the relatively low metal thickness of the redistribution layer in the laminate, low package resistances are difficult to obtain. Therefore, GaN chip packaging concepts employing leadframe (LF) technology have been proposed to overcome some of the above drawbacks.

### Summary

According to an aspect of the disclosure, a chip package includes a first plate-shaped metal carrier structure, a second plate-shaped metal carrier structure and a third plate-shaped metal carrier structure. The chip package further includes a first GaN chip sandwiched between the first metal carrier structure and the second metal carrier structure and a second GaN chip sandwiched between the second metal carrier structure and the third metal carrier structure. The chip package is configured to be attached to an application board in an orientation in which the plate-shaped metal carrier structures and the GaN chips are inclined, in particular vertical relative to the application board.

### Brief description of the drawings

In the drawings, like reference numerals designate corresponding similar parts. The features of the various illustrated embodiments can be combined unless they exclude each other and/or can be selectively omitted if not described to be necessarily required. Embodiments are depicted in the drawings and are exemplarily detailed in the description which follows.
Figure 1A is a sectional view of a first example of a chip package.
Figure 1B is a sectional view of a second example of a chip package.
Figure 2 is a top view on an example of a GaN chip.
Figure 3A is a bottom view (footprint) of an exemplary chip package as, e.g., the exemplary chip package of Figure 1A.
Figure 3B is a bottom view (footprint) of an exemplary chip package as, e.g., the exemplary chip package of Figure 1B.
Figure 4A is the partial sectional view along line B-B of Figure 3A of the chip package of Figure 1A without mold compound.
Figure 4B is a partial sectional view along line B-B of Figure 3B of the chip package of Figure 1B without mold compound.
Figures 5A-5K are sectional views along line A-A of Figure 3B corresponding to stages of manufacturing the exemplary chip package of Figure 1B.
Figures 6A-6G are perspective top views corresponding to stages of manufacturing an exemplary chip package.
Figure 7A and 7B are top views of examples of GaN chips with different chip pad layouts for, e.g., manufacturing the exemplary chip package of Figure 6G.

### Detailed description

As used in this specification, the terms "electrically connected" or "electrically coupled" or similar terms are not meant to mean that the elements are directly contacted together; intervening elements may be provided between the "electrically connected" or "electrically coupled" elements, respectively. However, in accordance with the disclosure, the above-mentioned and similar terms may, optionally, also have the specific meaning that the elements are directly contacted together, i.e. that no intervening elements are provided between the "electrically connected" or "electrically coupled" elements, respectively.

Further, the words "over" or "beneath" or similar terms with regard to a part, element or material layer formed or located or arranged "over" or "beneath" a surface may be used herein to mean that the part, element or material layer be located (e.g. placed, formed, arranged, deposited, etc.) "directly on" or "directly under", e.g. in direct contact with, the implied surface. The word "over" or "beneath" or similar terms used with regard to a part, element or material layer formed or located or arranged "over" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

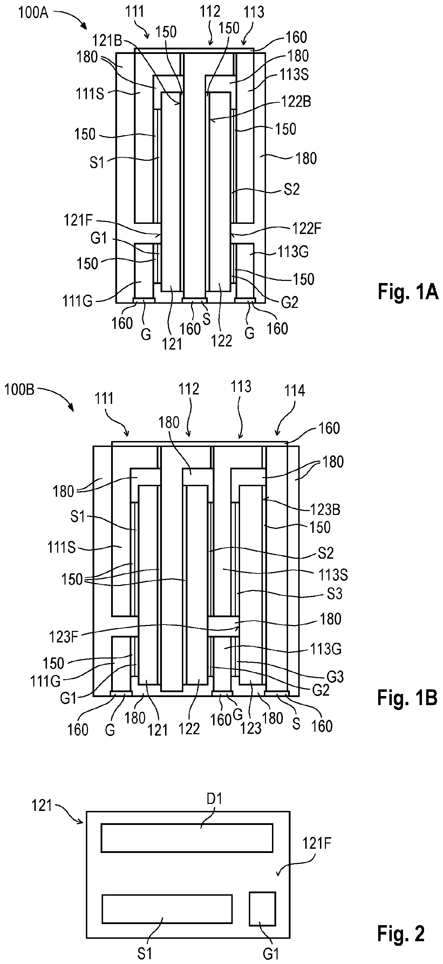

A first exemplary chip package 100A and a second exemplary chip package 100B are illustrated in Figures 1A, 3A, 4A and 1B, 3B, 4B, respectively. The first chip package 100A includes a first metal carrier structure 111, a second metal carrier structure 112 and a third metal carrier structure 113. The metal carrier structures 111, 112, 113 are plate-shaped.

The first chip package 100A further includes a first GaN chip 121 and a second GaN chip 122. The first GaN chip 121 is sandwiched between the first metal carrier structure 111 and the second metal carrier structure 112. The second GaN chip 122 is sandwiched between the second metal carrier structure 112 and the third metal carrier structure 113.

The first chip package 100A is configured to be attached to an application board (not shown) in an orientation in which the plate-shaped metal carrier structures 111, 112, 113 and the GaN chips 121, 122 are inclined, in particular vertical relative to the application board. In other words, the first chip package 100A is a "vertical" chip package.

The second chip package 100B (see Figures 1B, 3B, 4B) includes the same elements as the first chip package 100A and is further "extended" by including a third GaN chip 123 and a fourth metal carrier structure 114.

The second GaN chip 122 may, e.g., be identical with the first GaN chip 121 and/or the third GaN chip 123 may, e.g., be identical with the first GaN chip 121. Generally, all GaN chips 121, 122, 123 may be identical.

Generally, a chip package in accordance with the disclosure may, e.g., include a number N of GaN chips 121, 122, 123 and a number N+1 of plate-shaped metal carrier structures 111, 112, 113, 114, with N being an integer equal to or greater than 2. Differently stated, a chip package in accordance with the disclosure may be designed as a stack of metal carrier structures 111, 112, 113, 114 and GaN chips 121, 122, 123, wherein the metal carrier structures 111, 112, 113, 114 and GaN chips 121, 122, 123 are arranged in alternating order in the chip package.

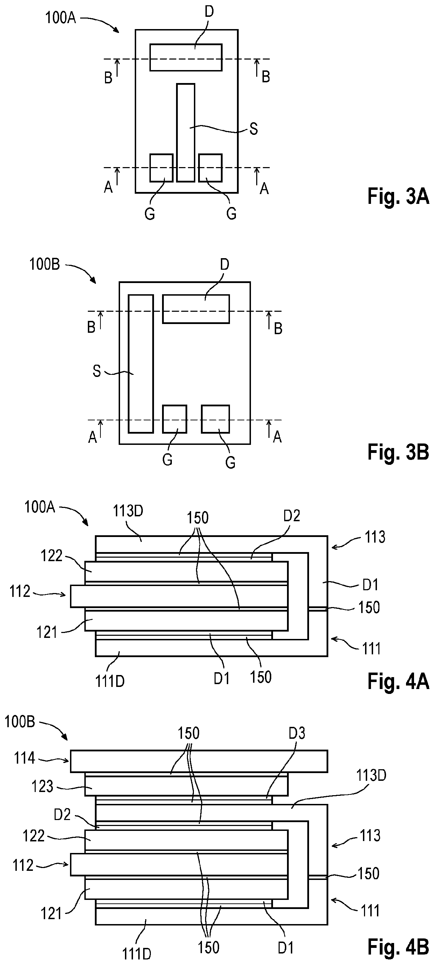

The two or more GaN chips 121, 122, 123 may be arranged face-up and face-down in alternating order. For example, referring to Figure 1A, the first GaN chip 121 has a first (front) side 121F and a second (back) side 121B opposite the first side 121F. The first side 121F may include a gate chip pad G1, a drain chip pad D1 (see Figure 4A) and a source chip pad S1. Likewise, the second GaN chip 122 has a first (front) side 122F and a second (back) side 122B opposite the first side 122F, wherein the first side 122F may include a gate chip pad G2, a drain chip pad D2 (see Figure 4A) and a source chip pad S2. The second metal carrier structure 112 faces the second side 121B of the first GaN chip 121 and the second side 122B of the second GaN chip 122.

Figure 2 illustrates a top view of the first (front) side 121F of the first GaN chip 121. For example, the drain chip pad D1 may extend along one lateral side of the first GaN chip 121, while the source chip pad S1 and the gate chip pad G1 are arranged along the opposite lateral side of the GaN chip 121.

Generally, the illustration of Figure 2 may also apply for the second GaN chip 122 and/or the third GaN chip 123 and/or for all N GaN chips contained in the chip package.

The second side 121B of the first GaN chip 121 (as well as for any other GaN chip 122, 123) may, e.g., be void of any chip pads.

The GaN chips 121, 122, 123 described herein may be transistor GaN chips, in particular power transistor GaN chips. For example, the GaN chips 121, 122, 123 may, e.g., be HEMT (high electron mobility transistor) devices.

The first metal carrier structure 111 may include a gate segment 111G, a source segment 1115 and a drain segment 111D. Similarly, the third metal carrier structure 113 may include a gate segment 113G, a source segment 113S and a drain segment 113D. The gate chip pads G1, G2 of the first and second GaN chips 121, 122 are connected to the gate segments 111G, 113G of the first and third metal carrier structures 111, 113, respectively. The drain chip pads D1, D2 of the first and second GaN chips 121, 122 are connected to the drain segments 111D, 113D of the first and third metal carrier structures 111, 113, respectively. The source chip pads S1, S2 of the first and second GaN chips 121, 122 are connected to the source segments 1115, 113S of the first and third metal carrier structures 111, 113, respectively.

The second metal carrier structure 112 may, e.g., be a single, non-segmented part.

The second metal carrier structure 112 may, e.g., be held on a common source (S) potential. To this end, the second metal carrier structure 112 may be connected, e.g., to the source segment 1115 of the first metal carrier structure 111 and, e.g., to the source segment 113S of the third metal carrier structure 113.

Referring to the "extended" chip package 100B of Figures 1B, 3B and 4B, the fourth metal carrier structure 114 may be formed similar than the second metal carrier structure 112. For example, the fourth metal carrier structure 114 may (also) be formed of a single, non-segmented part. The fourth metal carrier structure 114 may (also) be held on the common source potential. To this end, the fourth metal carrier structure 114 may, e.g., be connected to the source segment 113S of the third metal carrier structure 113.

Further, Figure 1B illustrates that the third GaN chip 123 is sandwiched between the third metal carrier structure 113 and the fourth metal carrier structure 114. The third GaN chip 123 has a first (front) side 123F and a second (back) side 123B opposite the first side 123F. The first side 123F may include a gate chip pad G3, a drain chip pad D3 (see Figure 4A) and a source chip pad S3. The fourth metal carrier structure 114 may face the second side 123B of the third GaN chip 123.

All chip pads G1-G3, S1-S3, D1-D3 may, e.g., be attached to the respective metal carrier structures 111, 112, 113, 114 by bond material 150. The bond material 150 may, e.g., be a sinter bond material.

The first chip package 100A and the second chip package 100B may include a mold compound body 180. The mold compound body 180 embeds the GaN chips 121, 122, 123 and the metal carrier structures 111, 112, 113, 114 of the chip package 100A, 110B.

In Figures 1A and 1B the footprint side of the package 100A, 100B is at the bottom side of the mold compound 180. The drain package terminal D, the source package terminal S and the at least one gate package terminal G are exposed at the footprint side of the mold compound body 180.

Further, at least one of the metal carrier structures 111, 112, 113, 114 may, e.g., be exposed at the top side of the mold compound body 180. This allows a heat sink (not shown) to be attached to the at least one exposed metal carrier structure 111, 112, 113, 114.

For example, all metal carrier structures 111, 112, 113, 114 may be exposed at the top side of the mold compound body 180. As all metal carriers structures 111 (source segment 1115 thereof), 112, 113 (source segment 113S thereof), 114 may be connected to each other and may be held on (common) source potential, a heat sink held at (low) source potential can be attached to all metal carrier structures 111, 112, 113, 114 for package top side cooling (TSC package). Reference sign 160 refers to a bond material which may, e.g., be plated on the exposed metal carrier structures 111, 112, 113, 114 and/or on the segments forming the terminals at the bottom of the chip package 100A.

Figure 3A illustrates a bottom view (footprint) of the first chip package 100A. G denotes the gate terminal of the package 100A, S denotes the source terminal of the package 100A and D denotes the drain terminal of the package 100A. The sectional views of Figures 1A and 4A illustrate that the gate terminals G may be formed by ends of the first and third gate segments 111G, 113G, the source terminal S may be formed by an end of the second metal carrier structure 112 and/or the drain terminal D may be formed by parts of the drain segments 111D, 113D of the first and third metal carrier structures 111, 113, respectively. For example, the source terminal S may, e.g., be formed exclusively by the second metal carrier structure 112.

For example, the source terminal S of the first chip package 100A may be arranged between two gate terminals G. The drain terminal D may be arranged at an opposite lateral side of the first chip package 100A. It is to be noted that Figure 1A illustrates a sectional view along line A-A of Figure 3A, while Figure 4A illustrates a sectional view along line B-B of Figure 3A.

Referring to the second chip package 100B, a possible footprint of this package is shown in Figure 3B. The gate terminals G may, e.g., run along one lateral side of the second chip package 100B, while the drain terminal D may be arranged along a lateral side of the second chip package 100B opposite to the lateral side where the gate terminals G are located. The source terminal S may, e.g., extend along a lateral side which extends between both of the aforementioned lateral sides. For example, the source terminal S may, e.g., be formed exclusively by the fourth metal carrier structure 114.

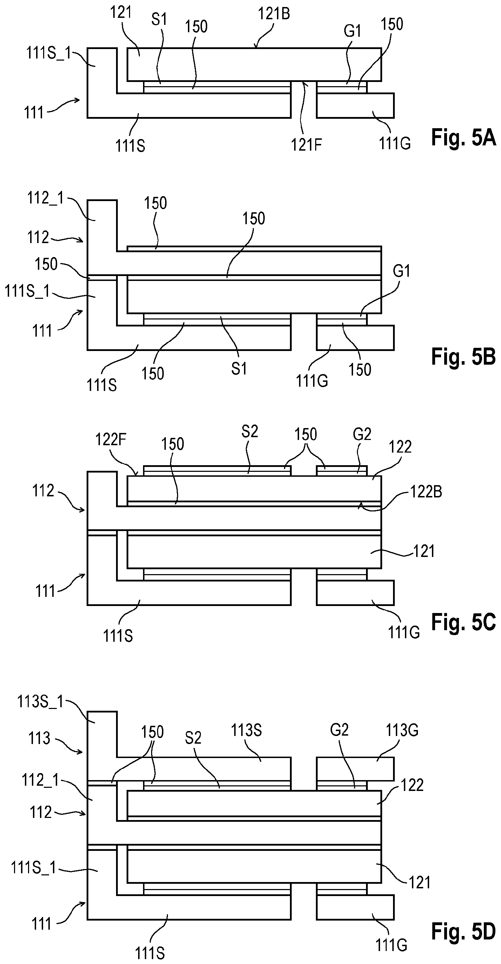

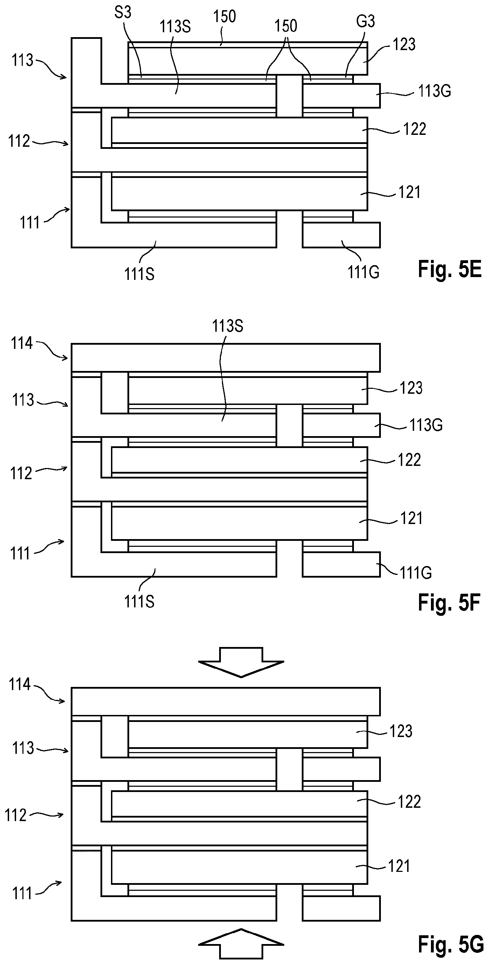

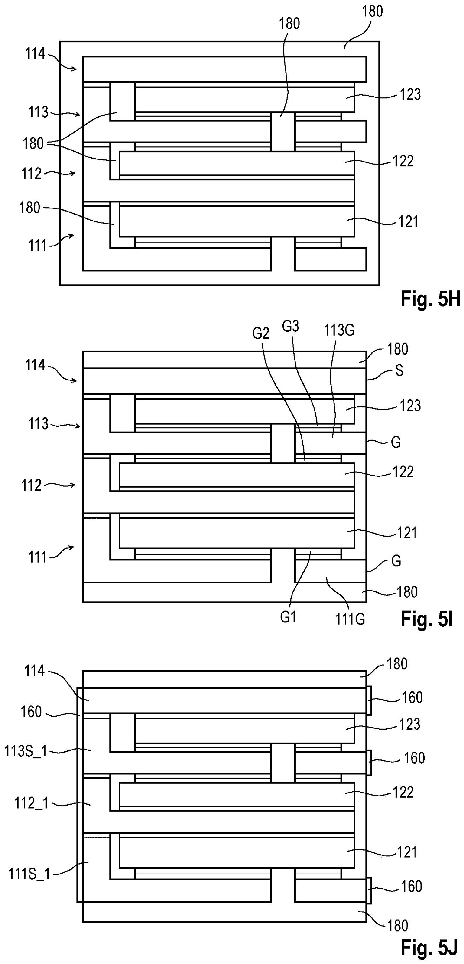

Figures 5A-5K illustrate stages of manufacturing the exemplary second chip package 100B. The stages of Figures 5A-5D and 5G-5K also apply to the manufacturing of the first chip package 100A.

Referring to Figure 5A, the first metal carrier structure 111 is provided. The first metal carrier structure 111 may, e.g., be a leadframe (LF). The first metal carrier structure 111 may include the gate segment 111G, the source segment 1115 and the drain segment 111D. Since all Figures 5A-5K are within the sectional plane of the gate and source segments (line A-A of Figure 3B), the drain segments of the metal carrier structures 111, 113 are not visible in Figures 5A-5K.

The first GaN chip 121 is flip-chip attached (first side 121F down) to the first metal carrier structure 111. The gate, source and drain chip pads G1, S1, D1 may be placed on the corresponding segments (gate segment 111G, source segment 1115, drain segment 111D) of the first metal carrier structure 111 at areas where the segments are plated with bond material 150.

The bond material 150 may, e.g., be a material configured for sintering, e.g. Ag sintering. For example, TiNiVAg may be used as a bond material 150.

As shown in Figure 5A, the source segment 1115 may include a segment part 111S_1 which extends in a direction perpendicular to the plane of the first metal carrier structure 111. The top end of the segment part 111S_1 may, e.g., be on approximately the same level as the second side 121B of the first GaN chip 121.

Referring to Figure 5B, the second metal carrier structure 112 may be placed on the second side 121B of the first GaN chip 121. The second metal carrier structure 112 may have selective areas which are plated with bond material 150. The plated areas may, e.g., be aligned with the segment part 111S_1 of the first metal carrier structure 111 and with the second side 121B of the first GaN chip 121. In other examples, the segment part 111S_1 of the first metal carrier structure 111 and/or the second side 121B of the first GaN chip 121 may be plated with the bond material 150.

The bond material 150, which may be used for the attach of the second metal carrier structure 112 to the first GaN chip 121 and, e.g., to the source segment 1115 of the first metal carrier structure 111 can be the same bond material 150 as used in Figure 5A. In other words, here and in all other metal carrier structure and/or GaN chip attach processes described herein, in particular also for the backside GaN-chip attach processes, the same bond material 150 (e.g., Ag sintering material) may be used.

Similar as the first metal carrier structure 111, the second metal carrier structure 112 may also include a part 112_1 which may extend perpendicular to the plane of the second metal carrier structure 112.

The second metal carrier structure 112 (as well as the third and the fourth metal carrier structures 113, 114) may be referred to as a clip. In contrast to the first metal carrier structure 111, which may, e.g., be implemented as a leadframe (or, more specifically, a zone of an extended leadframe which is composed of an array or pattern of such leadframe zones), the following metal carrier structures 112, 113, 114 may be separate parts which are individually attached to each GaN chip 121, 122, 123 by, e.g., a pick-and-place process.

Figure 5C illustrates the attach process of the second GaN chip 122 to the second metal carrier structure 112. The second GaN chip 122 is attached first (front) side 122F up.

Referring to Figure 5D, the third metal carrier structure 113 is attached. As mentioned before, the third metal carrier structure 113 may include a gate segment 113G, a source segment 113S and a drain segment 113D (not visible). These segments 113G, 113S, 113D may, e.g., be separate parts which are each applied by a respective pick-and-place process. In other examples, the gate, source and drain segments 113G, 113S, 113D may be connected to each other by, e.g., a handling structure such as, e.g., an adhesive foil or a pre-mold structure. In this case, the third metal carrier structure 113 can be applied by a single pick-and-place process. In other words, in some examples, a clip representing the third metal carrier structure 113 may be a compound clip including the gate, source and drain segments 113G, 113S, 113D and an electrically insulating handling material keeping these segments 113G, 113S, 113D together to form a single piece.

For the first chip package 100A, the stacking process may then end. For a package including more than two GaN chips, the alternating GaN chip and metal carrier structure stacking process is continued.

In this respect, Figure 5E illustrates the flip-chip-attach of the third GaN chip 123. Similar as the first and second metal carrier structures 111, 112, also the third metal carrier structure 113 (more specifically, the source segment 113S thereof) may, e.g., include a part 113S_1 which extends in the direction perpendicular to the (plate-shaped) third metal carrier structure 113. Reference is made to the description of the attachment of the first GaN chip 121 to avoid reiteration.

In Figure 5F the fourth metal carrier structure 114 is attached to the third GaN chip 123 and, e.g., to the part 113S_1 of the third metal carrier structure 113. Reference is made to the description of the attachment of the second metal carrier structure 112 to avoid reiteration.

Figure 5G illustrates a bonding process applied to the stack of metal carrier structures 111, 112, 113, 114 and GaN chips 121, 122, 123 by, e.g., sintering. In a sinter process a top and bottom compression (see arrows) is applied. Further, energy (e.g., heat) is applied for sintering the sinter particles included in the bond material (e.g., sintering paste) 150.

Subsequently, as shown in Figure 5H, the mold compound body 180 may be formed by a molding process. The mold compound body 180 may partly or completely cover the stack of metal carriers 111, 112, 113, 114 and GaN chips 121, 122, 123.

The mold compound body 180 typically encloses a plurality of such stacks, which are arranged next to each other in form of an array or pattern. Figure 5I illustrates the singulation of separate packages out of this embedded wafer level structure. For example, a saw singulation process may be used. This process may, e.g., also be used to expose the parts 111S_1, 112_1, 113S_1 at the top side of the package and/or the package terminals G, S, D at the bottom side of the package. In Figure 5I, the exposed source terminal S and two exposed gate terminals G are illustrated.

While the gate package terminal G of the gate segment 111G of the first metal carrier structure 111 is connected to the gate chip pad G1 of the first GaN chip 121, the gate package terminal G of the gate segment 113G of the third metal carrier structure 113 is a common gate connected to the gate chip pad G2 of the second GaN chip 122 and to the gate chip pad G3 of the third GaN chip 123.

Subsequently, the exposed parts 111S_1, 112_1, 113S_1 and, e.g., an end part of the fourth metal carrier structure 114 may be plated with a bond material 160. Similarly, the package terminals G, S and D may be plated with the bond material 160. The bond material 160 may, e.g., be the same material as the bond material 150. Other bond materials 160 such as, e.g., solder and/or a conductive adhesive may also be used for top side and/or footprint package plating.

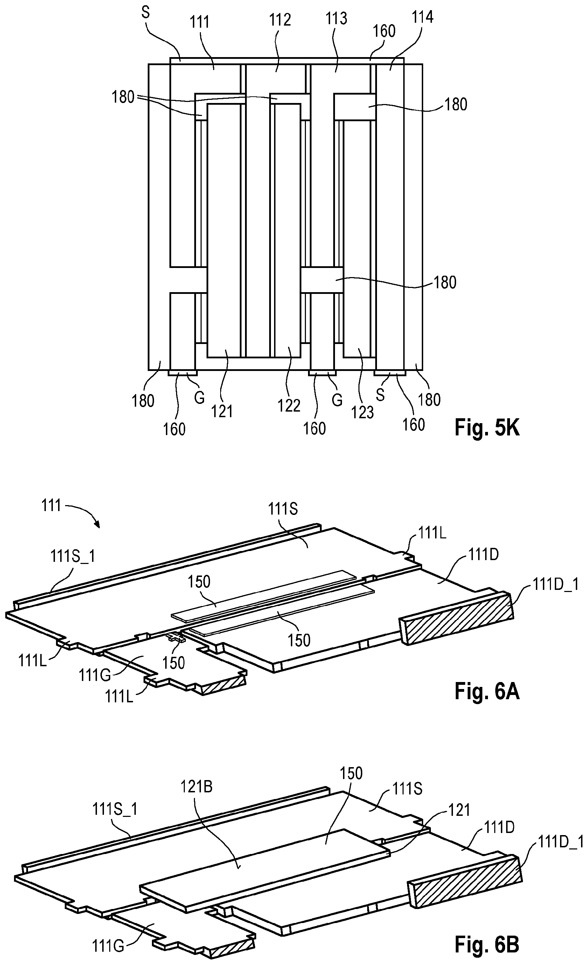

A final singulation process from leadframe (e.g., of the leadframe zone representing the first metal carrier structure 111) is shown in Figure 5K. The final singulation from leadframe forms individual chip packages (here, the second chip package 100B is shown by way of example). The chip package can then be brought in the upright position as shown in Figure 5K. The singulation from leadframe may be followed by testing steps, etc.

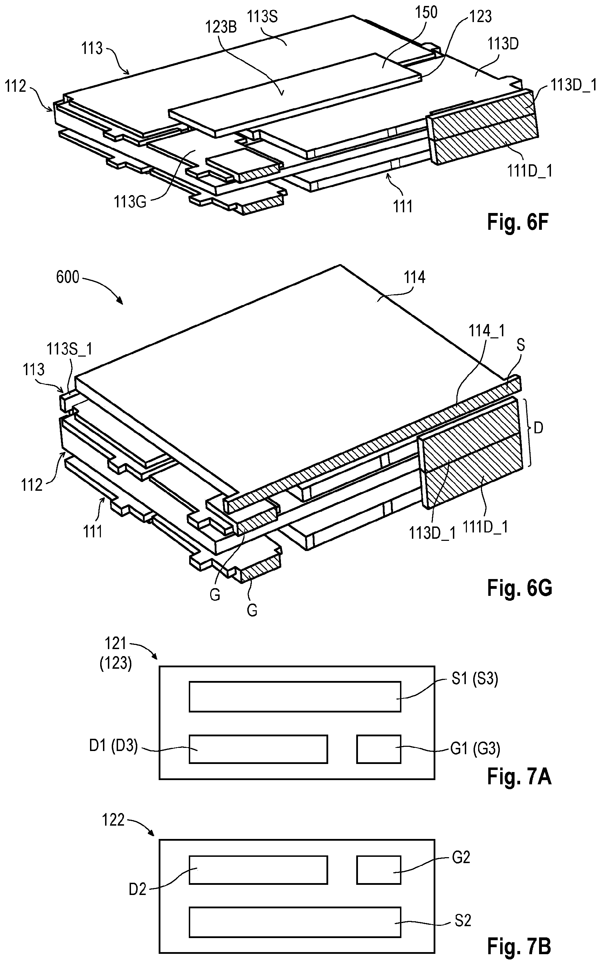

Figures 6A-6G illustrate stages of the manufacturing process of Figures 5A-5G in perspective top view illustrations for an exemplary chip package 600 (see Figure 6G). The plate-shaped first metal carrier structure 111 (leadframe) is shown in Figure 6A. Leads connecting to neighboring first metal carrier structures 111 (or leadframe zones, not shown) are denoted by reference sign 111L. Bond material 150 is disposed on each of the segments 111G, 111S, 111D on areas which are aligned with the chip pads G1, S1, D1 of the first GaN chip 121, see Figure 2.

The segment part 111S_1, which extends perpendicular to the plane of the first metal carrier structure 111, may run along a majority of the longitudinal extension. The segment part 111D_1 may be disposed at a portion of the drain segment 111D which is remote from the gate segment 111G. Differently stated, the segment part 111D_1 may be disposed adjacent to one end of the first metal carrier structure 111 and the gate segment 111G may be disposed adjacent the opposite end of the first metal carrier structure 111.

The first GaN chip 121 is disposed on the first metal carrier structure 111, see Figure 6B. The plated areas of the segments 111G, 1115 and 111D are contacted by the chip pads G1, S1 and D1 of the first GaN chip 121, respectively. To fit the construction of exemplary chip package 600 (see Figure 6G), the drain, source and gate chip pads D1, S1, G1 of the first GaN chip 121 may be arranged as shown in Figure 7A (i.e., compared to Figure 2, S1 and D1 are interchanged in position). Bond material 150 may, e.g., already be deposited on the second (back) side 121B of the first GaN chip 121.

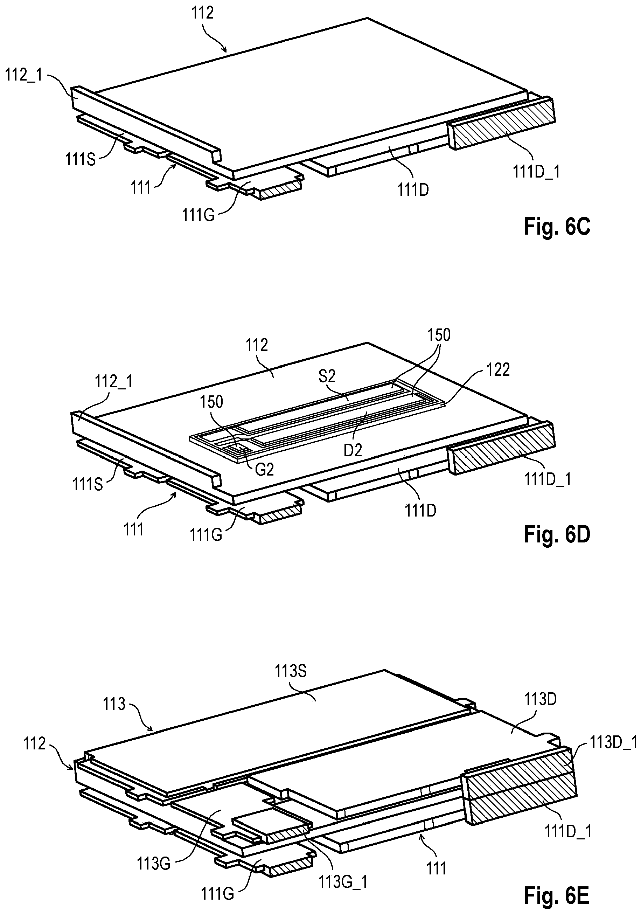

Referring to Figure 6C, the second metal carrier structure 112 (first clip) is disposed on the first GaN chip 121. The part 112_1 may, e.g., be arranged at a side of the second metal carrier structure 112 which is perpendicular to the side of the first metal carrier structure 111 along which the segment part 111S_1 is running. The second metal carrier structure 112 can, for example, be a one-piece continuous plate.

The second GaN chip 122 is placed on the second metal carrier structure 112, see Figure 6D. The bond material 150 may, e.g., already be applied on the gate, source and drain pads G2, S2, D2 of the second GaN chip 122. To fit the construction of exemplary chip package 600 (see Figure 6G), the drain, source and gate chip pads D2, S2, G2 of the second GaN chip 122 may be arranged as shown in Figure 7B.

Figures 7A and 7B illustrate that two different GaN chips 121, 122 with mirrored drain, gain and source chip pads may be used for the exemplary chip package 600. In both GaN chips 121, 122, the source chip pad S1, S2 is arranged opposite the drain D1, D2 and gate G1, G2 chip pads.

In Figure 6E the third metal carrier structure 113 including the gate segment 113G, the source segment 113S and the drain segment 113D is placed on the second GaN chip 122. As mentioned before, the segments 113G, 113S, 113D may be separate pieces which may each be placed by a pick-and-place operation. In other examples, the segments 113G, 113S, 113D may be held together by a handling structure, e.g. they may be pre-molded to form a single piece composed of the segments 113G, 113S, 113D and mold material or held together by an adhesive tape (not shown). The drain segment 113D may, e.g., include a segment part 113D_1 which extends perpendicular to the plane of the third metal carrier structure 113. The segment part 113D_1 may be disposed at a portion of the drain segment 113D which is remote from the gate segment 113G. Differently stated, the segment part 113D_1 may be disposed adjacent to one end of the third metal carrier structure 113 and the gate segment 113G may be disposed adjacent the opposite end of the third metal carrier structure 113.

Figure 6F illustrates the placement of the third GaN chip 123 on the third metal carrier structure 113. The third GaN chip 123 is placed face-down (flip-chip). The first side 123F of the third GaN chip 123 may have the same chip pad arrangement D3, S3, G3 as the first side 121F of the first GaN chip, 121, see Figure 7A. Bonding material 150 may, e.g., be disposed on the second (back) side 123B of the third GaN chip 123.

Referring to Figure 6G, the fourth metal carrier structure 114 (e.g., a one-piece continuous plate) is placed on the third GaN chip 123.

The manufacturing process may then proceed by performing the steps shown in Figures 5G-5K.

The package terminals G, D and S are shown as hatched faces of the corresponding segments 111G, 113G or segment parts 111D_1, 113D_1, 114_1 of the metal carrier structures 111, 113, 114. As can be seen from Figure 6G, the drain package terminal D may, e.g., be formed by the part 111D_1 of the drain segment 111D and the part 113D_1 of the drain segment 113D. The source package terminal S may, e.g., be formed by the part 114_1 of the fourth metal carrier structure 114. The part 114_1 of the fourth metal carrier structure 114 may, e.g., extend along a majority of the longitudinal extension (or, e.g., substantially the full longitudinal extension) of the fourth metal carrier structure 114.

Two gate package terminals G may be provided. One of the gate package terminals G may be formed by an end face of the gate segment 111G and the other gate package terminal G may be formed by an end face of the gate segment 113G.

In general, the stacking concept described above for the examples N = 2 and N = 3 may be extended to higher numbers N of GaN chips 121, 122, 123 and N+1 of metal carrier structures 111, 112, 113, 114, with N = 4, 5, 6, etc. Optionally, GaN chips 121, 122, 123 with different chip pad layouts (see Figures 7A, 7B) for face-down and face-up mounting may be used as exemplified by chip package 600. This allows to form a chip package 600 with minimum vertical height. All chip packages 100A, 100B, 600 may include a mold compound body 180 (not shown in Figure 6G) as described above.

In all examples disclosed herein, the GaN transistor chips 121, 122, 123 may be, e.g., capable of switching high currents and/or medium voltages or high voltages (e.g., more than 50 V or 100 V or 200 V or 300 V or 400 V or 500 V blocking voltage). In particular, exemplary transistor packages 100A, 100B as disclosed herein may operate in the medium voltage (MV) range, in which the blocking voltage is equal to or greater than or less than 200 V or 150 V or 100 V or 50 V.

In all examples disclosed herein, the metal carrier structures 111, 112, 113, 114 (leadframe(s) and/or clips) may have a thickness equal to or greater than or less than 150 um or 200 µm or 250 µm or 500 µm or 900 µm or 1.27 mm or 2.0 mm.

### EXAMPLES

The following examples pertain to further aspects of the disclosure:

Example 1 is a chip package. The chip package includes a first plate-shaped metal carrier structure, a second plate-shaped metal carrier structure and a third plate-shaped metal carrier structure. The chip package further includes a first GaN chip sandwiched between the first metal carrier structure and the second metal carrier structure and a second GaN chip sandwiched between the second metal carrier structure and the third metal carrier structure. The chip package is configured to be attached to an application board in an orientation in which the plate-shaped metal carrier structures and the GaN chips are inclined, in particular vertical relative to the application board.

In Example 2, the subject matter of Example 1 can optionally include wherein the first GaN chip has a first side and a second side opposite the first side, wherein the first side comprises a gate chip pad, a drain chip pad and a source chip pad; the second GaN chip has a first side and a second side opposite the first side, wherein the first side comprises a gate chip pad, a drain chip pad and a source chip pad; and wherein the second metal carrier structure faces the second side of the first GaN chip and the second side of the second GaN chip.

In Example 3, the subject matter of Example 2 can optionally include wherein the first metal carrier structure comprises a gate segment, a drain segment and a source segment; the third metal carrier structure comprises a gate segment, a drain segment and a source segment; and the second metal carrier structure is connected to the source segment of the first metal carrier structure and to the source segment of the third metal carrier structure.

In Example 4, the subject matter of any of the preceding Examples can optionally include wherein the second metal carrier structure is a single, non-segmented part.

In Example 5, the subject matter of any of the preceding Examples can optionally include wherein the first metal carrier structure comprises a leadframe.

In Example 6, the subject matter of any of the preceding Examples can optionally include wherein the second metal carrier structure comprises a clip and/or the third metal carrier structure comprises a clip.

In Example 7, the subject matter of any of the preceding Examples can optionally further include a fourth plate-shaped metal carrier structure; and a third GaN chip sandwiched between the third metal carrier structure and the fourth metal carrier structure.

In Example 8, the subject matter of Example 7 can optionally include wherein the third GaN chip has a first side and a second side opposite the first side, wherein the first side comprises a gate chip pad, a drain chip pad and a source chip pad, and wherein the fourth metal carrier structure faces the second side of the third GaN chip.

In Example 9, the subject matter of Example 7 or 8 can optionally include wherein the fourth metal carrier structure is a single, non-segmented part.

In Example 10, the subject matter of Example 3 and any of Examples 7 to 9 can optionally include wherein the fourth metal carrier structure is connected to the source segment of the third metal carrier structure.

In Example 11, the subject matter of any of the preceding Examples can optionally further include a mold compound body embedding the GaN chips and the metal carrier structures of the chip package, the mold compound body having a footprint side and a top side opposite the footprint side, wherein a drain package terminal, a source package terminal and at least one a gate package terminal are exposed at the footprint side of the mold compound body.

In Example 12, the subject matter of Example 11 can optionally include wherein the drain package terminal is formed by a part of the first metal carrier structure and a part of the third metal carrier structure.

In Example 13, the subject matter of Examples 7 to 10 and Example 11 can optionally include wherein a gate package terminal to which the second GaN chip and the third GaN chip are connected is formed by a part of the third metal carrier structure.

In Example 14, the subject matter of any of Examples 10 to 13 can optionally include wherein at least one of the metal carrier structures is exposed at the top side of the mold compound body.

In Example 15, the subject matter of Example 14 can optionally further include a heatsink attached to the at least one metal carrier structure exposed at the top side of the mold compound body.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A chip package, comprising:
a first plate-shaped metal carrier structure;
a second plate-shaped metal carrier structure;
a third plate-shaped metal carrier structure;
a first GaN chip sandwiched between the first metal carrier structure and the second metal carrier structure; and
a second GaN chip sandwiched between the second metal carrier structure and the third metal carrier structure; wherein
the chip package is configured to be attached to an application board in an orientation in which the plate-shaped metal carrier structures and the GaN chips are inclined, in particular vertical relative to the application board.

2. The chip package of claim 1, wherein
the first GaN chip has a first side and a second side opposite the first side, wherein the first side comprises a gate chip pad, a drain chip pad and a source chip pad;
the second GaN chip has a first side and a second side opposite the first side, wherein the first side comprises a gate chip pad, a drain chip pad and a source chip pad; and
wherein the second metal carrier structure faces the second side of the first GaN chip and the second side of the second GaN chip.

3. The chip package of claim 2, wherein
the first metal carrier structure comprises a gate segment, a drain segment and a source segment;
the third metal carrier structure comprises a gate segment, a drain segment and a source segment; and
the second metal carrier structure is connected to the source segment of the first metal carrier structure and to the source segment of the third metal carrier structure.

4. The chip package of any of the preceding claims, wherein the second metal carrier structure is a single, non-segmented part.

5. The chip package of any of the preceding claims, wherein the first metal carrier structure comprises a leadframe.

6. The chip package of any of the preceding claims, wherein the second metal carrier structure comprises a clip and/or the third metal carrier structure comprises a clip.

7. The chip package of any of the preceding claims, further comprising:
a fourth plate-shaped metal carrier structure; and
a third GaN chip sandwiched between the third metal carrier structure and the fourth metal carrier structure.

8. The chip package of claim 7, wherein the third GaN chip has a first side and a second side opposite the first side, wherein the first side comprises a gate chip pad, a drain chip pad and a source chip pad, and wherein
the fourth metal carrier structure faces the second side of the third GaN chip.

9. The chip package of claim 7 or 8, wherein the fourth metal carrier structure is a single, non-segmented part.

10. The chip package of claim 3 and any of claims 7 to 9, wherein
the fourth metal carrier structure is connected to the source segment of the third metal carrier structure.

11. The chip package of any of the preceding claims, further comprising:
a mold compound body embedding the GaN chips and the metal carrier structures of the chip package, the mold compound body having a footprint side and a top side opposite the footprint side, wherein a drain package terminal, a source package terminal and at least one a gate package terminal are exposed at the footprint side of the mold compound body.

12. The chip package of claim 11, wherein the drain package terminal is formed by a part of the first metal carrier structure and a part of the third metal carrier structure.

13. The chip package of any of claims 7 to 10 and claim 11, wherein a gate package terminal to which the second GaN chip and the third GaN chip are connected is formed by a part of the third metal carrier structure.

14. The chip package of any of claims 11 to 13, wherein at least one of the metal carrier structures is exposed at the top side of the mold compound body.

15. The chip package of claim 14, further comprising:
a heatsink attached to the at least one metal carrier structure exposed at the top side of the mold compound body.
